# FASCICULE DE BREVET EUROPEEN

(11) **EP 2 726 641 B1**
(45) Date de publication et mention de la délivrance du brevet: **06.05.2020**
(21) Numéro de dépôt: 12732976.1
(22) Date de dépôt: 27.06.2012
(51) Int. Cl.: C23C 14/20, C23C 14/54, C23C 14/56

(54) **PROCEDE ET MACHINE D'ENDUCTION D'UN SUBSTRAT EN BANDE CONTINUE ET DISPOSITIF DE DETERMINATION DE LA QUALITE D'ENDUCTION**
VERFAHREN UND VORRICHTUNG ZUR LAUFBANDSBESCHICHTUNG UND VORRICHTUNG ZUR BESTIMMUNG DER BESCHICHTUNGSQUALITÄT
METHOD AND APPARATUS FOR CONTINUOUS WEB COATING AND DEVICE FOR CHECKING THE COATING QUALITY

(30) Priorité: 30.06.2011 EP 11005340
(43) Date de publication de la demande: 07.05.2014
(73) Titulaire: BOBST MEX SA, 1031 Mex (CH)
(72) Inventeur: PILLOUD, Francis, 1815 Clarens (CH); RICHARD, Matthieu, 25160 Remoray (FR)
(86) Numéro de dépôt international: PCT/EP2012/002704
(87) Numéro de publication internationale: WO 2013/000570

(56) Documents cités:
- EP-A1- 1 028 174
- WO-A1-2008/004256
- FR-A1- 2 852 533
- GB-A- 750 693
- US-A1- 2010 307 414
- US-A1- 2011 039 017

## Description

La présente invention concerne un procédé pour enduire un substrat en bande continue. L'invention se rapporte également à une machine pour enduire un substrat en bande continue. L'invention concerne enfin un dispositif pour déterminer la qualité d'enduction à la surface d'un substrat enduit en bande continue.

Le marché des substrats en bande continue, c'est-à-dire des films flexibles, ayant une enduction sur l'une de leur face présente une grande diversité. Tout d'abord, les films d'emballage sont à la fois destinés à protéger les produits qu'ils emballent et à être également décoratifs. Leurs propriétés peuvent être comparées à des degrés divers à celles des récipients de verre ou de métal. Ces films peuvent rester transparents ou être imprimés de façon à apporter une amélioration esthétique. L'enduction à la surface des films permet de constituer des barrières à l'oxygène, à la vapeur d'eau, aux UV, ou à la lumière, selon l'effet recherché. Ils sont résistants, et respectueux de l'environnement en étant recyclables. Ils répondent aux normes rigoureuses, par exemple celles la FDA, concernant l'alimentation. Certains films sont aptes à passer au four à micro-onde. Ils sont aptes à être stérilisés. Sous forme laminée, ils possèdent une excellente résistance.

D'autres types de films flexibles enduits, par exemple avec une enduction métallisée, sont destinés à des applications différentes de celles de l'emballage. Ils peuvent présenter alors des propriétés telles que conducteurs électriques et optiques, anti réfléchissant et antistatique. Ils peuvent former des couches électroniquement conductrices ou TCC, pour « Transparent Conductive Coating », dont un exemple est un oxyde conducteur transparent ou TCO (« Transparent Conductive Oxide »). Des applications envisageables sont pour des circuits imprimés flexibles, des cellules photovoltaïques, et d'autres encore.

Ces films sont obtenus par enduction, à titre d'exemple par évaporation sous vide. Le procédé d'enduction s'effectue dans une machine au niveau d'une zone d'évaporation d'une chambre à vide, typiquement de 1 x 10⁻⁴ mbar 1 x 10⁻⁶ mbar. Le substrat vierge, généralement un film plastique flexible, par exemple d'une épaisseur comprise entre 5 µm et 35 µm, est introduit dans la machine sous la forme d'une première bobine. Le vide est fait au sein de la machine.

Le film est déroulé et défile à des vitesses allant jusqu'à 1500 m/min. Le film est refroidi par exemple au contact d'un tambour refroidi, lorsqu'il passe au dessus de la source d'évaporation ou lorsqu'il se trouve après la source d'évaporation. Dans le cas d'une enduction de métal, des fils métalliques, par exemple d'aluminium ultra-pur, sont amenés respectivement sur une série d'évaporateurs céramiques résistifs disposés sur la laize. Les fils d'aluminium fondent et s'évaporent à cet endroit. La vapeur d'aluminium se condense sur le substrat formant ainsi la couche d'enduit. Le film enduit est ensuite enroulé sur une deuxième bobine. La machine est remise à pression ambiante et la deuxième bobine est sortie.

Un tel procédé génère cependant des défauts au niveau du substrat enduit, par exemple des trous ou des micro-trous dans l'enduction, connus sous le nom de « pinholes », des variations d'épaisseurs de l'enduction, des absences d'enduction formant donc des grands trous, des griffures, des éraflures, des éclaboussures, des lignes doubles parallèles ou « tramway line », des nuages de micro-trous, voire des perforations du substrat enduit.

Pour diminuer la gâche de substrat enduit non-conforme et optimiser le procédé d'enduction, la qualité de l'enduction à la surface du substrat enduit obtenu doit être surveillée et doit être améliorée en conséquence.

### Etat de la technique

Une première technique consiste à observer en continu le substrat enduit pendant la production. Un opérateur est chargé de regarder le substrat à travers un hublot ménagé dans la paroi de la chambre à vide de la machine d'enduction. Si l'opérateur repère la présence de trous, il agit en conséquence sur les paramètres de fonctionnement de la machine.

Une telle technique est coûteuse en moyens humains, car elle nécessite la présence en continu d'un opérateur. L'opérateur doit maintenir une attention soutenue pendant la production. Cette technique est peu précise, car seuls les gros trous dans l'enduction sont repérés. Ainsi pour garantir une certaine qualité sans trous du substrat enduit, les vitesses de production sont très réduites, et la quantité de matériau d'enduction employé est importante.

On connaît également d'après le document WO 2008/004256 une machine pour produire des bobines de substrat en bande présentant un revêtement obtenu par dépôt sous vide. La machine comprend au moins un dispositif de traitement par dépôt sous vide, un dérouleur pour une bobine de substrat en bande vierge devant être revêtu, au moins une source de vaporisation, un capteur, et un enrouleur pour une bobine de substrat revêtu. Le capteur génère des informations pour au moins un paramètre du traitement se rapportant à une bobine en cours de traitement.

Le capteur est du type optique, radiofréquence ou analogue. Un exemple est donné avec un capteur mesurant l'épaisseur de l'enduction métallisée. Ce capteur génère un signal servant à une boucle d'asservissement pour réguler l'uniformité du dépôt. Ce signal est destiné à réguler la puissance électrique des moyens de vaporisation sous vide, la vitesse d'arrivée du fil métallique devant être fondu.

A la suite de la machine, le substrat revêtu est introduit dans une machine de reprise de type dérouleur-refendeur. Les informations au sujet de la bobine sont sous une forme qui est automatiquement intégrée par le dérouleur-refendeur. Dans le dérouleur refendeur, le déroulement du substrat en bande est arrêté, le substrat est coupé. Les zones de substrat revêtu présentant les défauts détectés par le capteur sont éliminées, puis le substrat est recollé.

Cependant, la présence d'un capteur et d'une régulation de la machine n'est pas suffisamment performante et rapide pour éviter la présence de zones de substrat non-conformes en termes de qualité. C'est pour cela que le dérouleur-refendeur avec sa fonction décrite est installé en aval de la machine. La suppression de substrat non-conforme génère ainsi de la gâche.

Le document WO 2004/086009 décrit un dispositif pour détecter des trous dans des feuilles en acier ayant une épaisseur environ égale à 0,25 mm, défilant successivement les unes après les autres. Le dispositif comprend tout d'abord un premier élément optique émetteur de lumière en direction de la feuille défilant. Le dispositif comprend ensuite un deuxième élément optique récepteur de lumière en provenance du premier élément optique. Le deuxième élément optique récepteur détecte la lumière qui est susceptible de passer à travers les trous de la feuille au défilant.

Cependant, ce dispositif de mesure est spécifique à la détection de trous dans des feuilles issues d'un laminoir. Un tel dispositif n'est pas adapté à détecter la présence de trous dans des substrats semi-transparents de très faible épaisseur ou des films. Ce document ne donne aucune indication sur l'utilisation d'un tel dispositif avec une boucle d'asservissement permettant de corriger automatiquement des défauts des feuilles pendant leur processus de fabrication.

Le document US2011039017 décrit une machine de revêtement d'un substrat en bande comprenant deux bobines, une source de vaporisation et une unité de pilotage recevant des informations de détecteurs optiques. Le film est par exemple métallique pour une déposition de SiO2 et le système de détection des défauts est optique sur une longueur d'onde déterminée. La source et le récepteur du détecteur optique, qui peuvent fonctionner en lumière visible, sont placés de part et d'autre du film.

### Exposé de l'invention

Un objectif principal de la présente invention consiste à mettre en œuvre un procédé d'enduction d'un substrat en bande continue, dans une machine d'enduction. Un deuxième objectif est de mettre en œuvre un procédé permettant de contrôler en continu l'enduction d'un substrat et d'adapter les paramètres de l'enduction en fonction des données contrôlées représentatives du substrat enduit. Un troisième objectif consiste à réaliser une machine pour enduire un substrat en bande continue avec un revêtement enduit, possédant une boucle de suivi de l'enduction en temps réel et en continu. Un quatrième objectif est d'obtenir un dispositif pour déterminer la qualité du revêtement enduit sur un substrat en bande continue défilant. Un autre objectif encore est de résoudre les problèmes techniques mentionnés pour les documents de l'état de la technique.

Conformément à un aspect de la présente invention, un procédé pour enduire un substrat en bande continue, dans une machine d'enduction, est défini par la revendication 1.

Autrement dit, le nombre et les dimensions des trous détectés dans l'enduction du substrat sont réduits par le réglage optimisé des paramètres dans l'étape d'enduction. En parallèle, la densité optique de la surface du substrat enduit est réglée de manière précise de manière à rester constante tout au long du processus d'enduction. L'effet barrière du substrat enduit et l'apparence du substrat enduit sont extrêmement dépendants des défauts du revêtement enduit à la surface.

Dans leur grande majorité, les trous détectés dans le substrat sont formés par une absence d'enduction sur le substrat. Les trous détectés dans le substrat sont également provoqués par l'enduction perforant le substrat et donc sur lequel il n'y a pas de dépôt d'enduction possible. Les trous dans le substrat vierge de départ devant être enduit sont aussi détectés.

Les réglages de la machine sont ajustés immédiatement de façon la plus appropriée en fonction de plusieurs paramètres mesurés. Des trous dans le substrat enduit ou des salissures de la surface enduite du substrat sont détectés, et la machine est asservie de façon à remédier immédiatement. Ces deux mesures supplémentaires rajoutées par l'invention permettent d'accroître la précision de son fonctionnement. Les paramètres trous détectés et densité optique sont maintenus aux valeurs cibles afin de garantir au producteur de substrat enduit un haut niveau de conformité et de qualité d'enduction.

La machine est asservie pour produire un film de qualité exempt de trous et avec une densité optique constante. La machine est asservie pour permettre une économie du matériau d'enduction. La machine est asservie de façon à produire un substrat enduit avec un meilleur rendement.

Ce contrôle constant permet d'arrêter une production si la bobine de substrat devant être enduit et/ou la bobine de substrat nouvellement enduit est détectée comme étant non-conforme. Ce contrôle constant permet d'arrêter la machine très rapidement et d'économiser de la matière, du substrat non enduit et dû matériau pour enduction.

Ce contrôle constant permet de cibler précisément les disfonctionnement de la machine d'enduction, par exemple salissures, encrassements, vieillissement, ce qui a également pour conséquence de diminuer les temps d'arrêt. Avec un asservissement de la machine, la charge de travail et les risques d'erreur de l'opérateur sont réduits.

Avec le procédé d'enduction, la qualité optimale de l'enduction est garantie à vitesse élevée d'enduction et avec une quantité plus faible de matériau d'enduction. Le coût du substrat enduit est réduit en raison de l'optimisation de l'étape de vaporisation du matériau enduit sur le substrat, grâce aux réglages continus de la machine. La gâche de substrat enduit non-conforme va être nulle ou extrêmement faible. La productivité de la machine est accrue. Ceci induit une diminution du coût du substrat enduit.

Dans un autre aspect de l'invention, une machine d'enduction d'un substrat en bande continue, équipée avec une enceinte sous vide, est définie par la revendication 6.

La machine est caractérisée en ce qu'elle comprend un dispositif pour déterminer la qualité du substrat enduit défilant, muni de moyens pour détecter en continu des trous dans toute ou partie du substrat enduit défilant et de moyens pour mesurer en continu une densité optique de toute ou partie de la surface du substrat enduit défilant, positionné entre le banc de vaporisation et la deuxième bobine, et connecté à l'unité de pilotage.

L'opérateur va accroître la vitesse de fonctionnement de la machine vers sa limite maximale acceptable, étant donné les caractéristiques en cours de salissures de la machine ou des caractéristiques en cours du substrat. L'opérateur va accroître la vitesse puisque les réglages sont optimisés pour réduire au maximum la présence de trous dans le substrat ou pour garantir une densité de trous et une densité optique optimisée conformes aux exigences souhaitées par le producteur de substrat.

Selon un autre aspect encore de l'invention, un dispositif pour déterminer la qualité d'enduction d'un substrat en bande continue défilant enduit, comme défini dans la revendication 9, est muni de moyens pour détecter en continu des trous dans toute ou partie du substrat, sous la forme d'un élément optoélectronique émetteur avec une source de lumière placé d'un côté du substrat, et un élément optoélectronique récepteur avec un récepteur de lumière placé de l'autre côté du substrat. Le dispositif est caractérisé en ce qu'il comprend en outre des moyens pour mesurer en continu une densité optique de toute ou partie de la surface du substrat enduit.

En d'autres termes, un seul dispositif assure à la fois la détection de trous et la mesure de densité optique. Cette intégration des deux mesures permet une bonne insertion du dispositif dans un environnement exigeant en termes de vide, de poussière, de température et d'encombrement.

### Brève description des dessins

L'invention sera bien comprise et ses divers avantages et différentes caractéristiques ressortiront mieux lors de la description suivante, de l'exemple non limitatif de réalisation, en référence aux dessins schématiques annexés, dans lesquels :
- la Figure 1 représente une vue latérale synoptique d'une machine d'enduction mettant en œuvre le procédé selon l'invention ; et
- la Figure 2 représente une vue d'un dispositif pour déterminer la qualité du substrat enduit.

### Exposé détaillé de modes de réalisation préférés

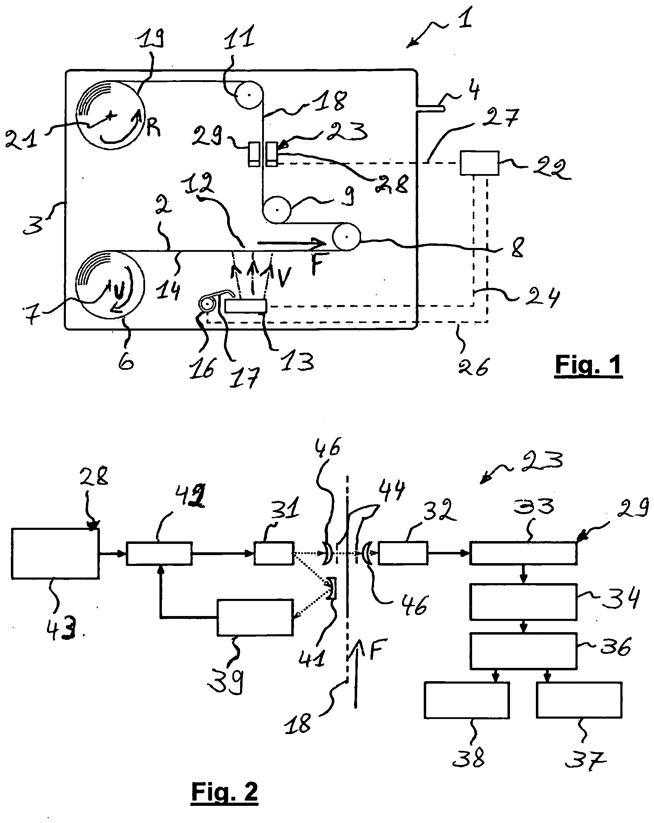

Comme l'illustre la Figure 1, une machine d'enduction, dans ce cas de métallisation sous vide 1, d'un substrat en bande continue ou web ou film vierge devant être enduit et donc métallisé 2 comprend une enceinte étanche 3. Un vide d'air est réalisé dans l'enceinte 3 grâce à un système de pompes à vide (non représenté) et de canalisations 4.

Le film vierge 2 est disponible sous la forme d'une première bobine 6. Avant de démarrer la production, l'enceinte est ouverte et la première bobine est insérée dans l'enceinte 3 en étant montée sur un axe de rotation 7. L'extrémité libre du film vierge 2 est tirée à travers l'enceinte 3. L'enceinte 3 est refermée de manière étanche, le vide est fait dans l'enceinte 3, puis le film vierge 2 commence à être déroulé (Flèche U en Figure 1) dans l'enceinte 3 sous vide.

La machine 1 comprend des moyens pour faire avancer et faire défiler (Flèche F) le film vierge 2 à partir de la première bobine 6. Ces moyens se présentent par exemple sous la forme de trois rouleaux de renvoi 8, 9 et 11. Ces moyens assurent également une tension du film vierge 2 tout au long du processus de métallisation. Les moyens pour faire défiler le film vierge 2 peuvent être plus complexes, variant en fonction du type de machine 1, de la laize du film 2 et du matériau du film 2.

Entre la première bobine 6 et le premier rouleau de renvoi 7, le film vierge 2 passe par une zone de métallisation 12. Un banc de vaporisation 13 est disposé à proximité de l'une des surfaces, ici la surface inférieure 14 du film vierge 2. Le banc 13 se présente sous la forme de plusieurs évaporateurs ou creusets céramiques résistifs chauffés disposés sur la laize du film vierge 2 et assurant la vaporisation du métal.

Un agencement de vaporisation 16 alimente en continu le banc 13 avec un matériau d'enduction, dans ce cas un matériau métallique à vaporiser à la surface du film vierge défilant. Le matériau métallique est ici de l'aluminium de haute pureté. L'agencement 16 comprend des bobines de fil d'aluminium 17 se déroulant. Chaque fil 17 entre progressivement dans chacun des creusets et fond alors à cet endroit. L'aluminium est vaporisé (Flèches V) à la surface inférieure 14 du film vierge 2 pour donner le film métallisé, c'est-à-dire aluminisé 18.

Dans certaines machines, des moyens de traitement à plasma (non visibles) peuvent être placés avant ou après la zone de métallisation 12. Ces moyens de traitement servent à nettoyer et préparer au revêtement d'aluminium la surface 14 du film vierge 2 ou à traiter la surface aluminisée du film aluminisé 18. La zone de métallisation 12 peut comprendre des moyens de refroidissement (non visibles) du film vierge 2 en cours de métallisation.

Après le troisième rouleau de renvoi 11, le film aluminisé 18 est enroulé (Flèche R en Figure 1) sur une deuxième bobine tracteur 19 montée sur un axe de rotation 21. En fin de processus de métallisation, ou dès qu'une partie ou la totalité de la bobine 6 de film vierge 2 est aluminisée, la machine 1 est arrêtée. L'enceinte 3 est remise à pression atmosphérique grâce aux canalisations 4. L'enceinte 3 est ouverte. La deuxième bobine 19 de film aluminisé 18 est sortie de l'enceinte 3.

Une unité de pilotage 22 de la machine 1 permet à un opérateur de régler de nombreux paramètres, tels que vitesse de déroulement de la première bobine 6, vitesse de défilement du film vierge 2 et du film aluminisé 18, puissance de chauffe de chacun des creusets de vaporisation 13, quantité de fils d'aluminium 17 arrivant pour être vaporisés, tension du film vierge 2 et du film aluminisé 18, vitesse d'enroulement de la deuxième bobine 19, et d'aùtres encore.

Selon l'invention, la machine 1 comprend un dispositif 23 pour déterminer la qualité de la couche d'aluminium enduite à la surface du film aluminisé 18. Le dispositif 23 est positionné dans l'enceinte 3 entre le banc de vaporisation 13 et la deuxième bobine 19, c'est-à-dire en aval de la zone de métallisation 12. Le dispositif 23 est par exemple inséré dans un intervalle compris entre le deuxième 9 et le troisième rouleau de renvoi 11.

Selon l'invention, le dispositif 23 est muni de moyens pour détecter en continu des trous dans le film aluminisé défilant 18. Le dispositif 23 est également muni de moyens pour mesurer en continu une densité optique ou OD pour « optical density » de la surface du film aluminisé défilant 18. Le dispositif 23 est connecté et communique avec l'unité de pilotage 22 de la machine 1.

Comme cela est visible en Figure 1 et uniquement à titre d'exemple, l'unité de pilotage 22 communique ainsi avec le banc de vaporisation 13 et l'agencement 16 par connexions électriques, respectivement 24 et 26, par exemple avec les moteurs déroulant les bobines de fils d'aluminium 17. Le dispositif 23 communique avec l'unité de pilotage 22 par connexion électrique 27.

Selon l'invention, le procédé pour aluminiser le film vierge 2, dans la machine de métallisation 1, comprend les étapes successives qui consistent à :
- dérouler U à partir de la première bobine 6, et faire défiler F le film vierge à métalliser 2 et/ou le film aluminisé 18,
- aluminiser en continu par vaporisation sous vide d'aluminium 17 sur l'une des surfaces 14 du film vierge défilant 2,
- déterminer la qualité du film aluminisé 18 et la qualité de métallisation du film aluminisé 18 en détectant en continu la présence de trous dans toute ou partie du film aluminisé défilant 18 et à la surface du film aluminisé défilant 18,
- déterminer la qualité de métallisation du film aluminisé 18 en mesurant en continu la densité optique de toute ou partie de la surface du film aluminisé défilant 18,
- générer des signaux qui sont fonctions des trous détectés et de la densité optique mesurée,
- ajuster en continu les réglages de la machine 1 en fonction des signaux générés, et
- enrouler R le film aluminisé 18 sur la deuxième bobine 19.

Les étapes consistant à détecter en continu la présence de trous et à mesurer en continu la densité optique du film aluminisé 18 sont de préférence mises en œuvre simultanément, grâce au dispositif 23. L'étape consistant à détecter en continu la présence de trous consiste également à déterminer la taille et/ou la superficie des trous et à les classifier. A titre d'exemple, les trous ont une taille de l'ordre de 0,1 mm à plusieurs mm de diamètre.

Avantageusement, les étapes consistant à détecter en continu la présence de trous et à mesurer en continu la densité optique sont mises en œuvre sur toute la laize du film aluminisé 18, en analysant l'entier de la superficie du film aluminisé 18.

De manière favorable, l'étape consistant à ajuster en continu les réglages de la machine 1 comprend une ou plusieurs des phases qui consistent à :
- à régler automatiquement et en continu une puissance de vaporisation du fil d'aluminium 17, dans l'étape consistant à métalliser le film vierge 2, en faisant du contrôle de la puissance de chauffe du banc de vaporisation 13 ; et/ou
- à régler automatiquement et en continu une vitesse d'arrivée de l'aluminium, en réglant la vitesse de déroulement des bobines de fil d'aluminium 17, dans l'étape consistant à métalliser le film vierge 2, de façon à ajuster la quantité de fil d'aluminium 17 arrivant pour être vaporisé ; et/ou
- à régler automatiquement et en continu une vitesse de défilement du film vierge 2 et/ou du film aluminisé 18 dans l'étape consistant à faire défiler F le film vierge 2, en régulant la vitesse de déroulement de la première bobine 6 et/ou de la vitesse d'enroulement de la deuxième bobine 19 ; et/ou
- à envoyer automatiquement et en continu un signal d'information à destination de l'opérateur correspondant à une opération à effectuer sur la machine 1, par exemple entretien, révision, nettoyage des creusets, changement des creusets, nettoyage de la machine 1, etc.

Le dispositif 23 comprend au moins un élément optoélectronique émetteur 28 et au moins un élément optoélectronique récepteur 29. L'élément émetteur 28 et l'élément récepteur 29 sont disposés respectivement l'un en face de l'autre de part et d'autre du film aluminisé 18. L'élément optoélectronique émetteur 28 est placé d'un côté du film aluminisé 18, et possède une source de lumière, apte à émettre de la lumière. L'élément optoélectronique récepteur 29 est placé de l'autre côté du film aluminisé 18, et possède un récepteur de lumière, apte à capter la lumière transmise à travers.le film aluminisé 18.

Le dispositif 23 comprend préférentiellement plusieurs modules (non visibles dans la Figure 1), comprenant chacun les moyens pour détecter en continu les trous et les moyens pour mesurer en continu la densité optique. Les modules sont disposés les uns par rapport aux autres de façon à être aptes à analyser 100% de la laize du film aluminisé 18. Chaque module comprend l'élément optoélectronique émetteur 28 et l'élément optoélectronique récepteur 29.

Le ou les éléments optoélectroniques émetteurs 28 et le ou les éléments optoélectroniques récepteurs 29 sont chacun montés sur un rail assurant la communication avec l'unité de pilotage 22. Les rails sont parallèles et placés de part et d'autre du film aluminisé 18.

A titre d'exemple, la source de lumière est une LED 31. La LED 31 émet une lumière, de longueur d'onde sensiblement comprise entre 400 nm et 700 nm, de préférence sensiblement égale à 550 nm, c'est-à-dire verte. Les deux mesures sont réalisées avec une seule LED 31 et une seule longueur d'onde d'émission.

Le récepteur de lumière est une photodiode 32. Avec une photodiode unique 32 pour la détection de trous et la mesure de densité optique, l'assemblage est simplifié, ce qui permet de réduire aussi les coûts.

En ce qui concerne le traitement du signal analogique, les moyens pour détecter les trous et les moyens pour mesurer la densité optique comprennent de préférence un étage d'amplification commun 33 dédiés aux signaux de détection des trous et aux signaux de densité optique. L'étage d'amplification commun 33 est connecté à la photodiode 32. Le ratio signal-bruit augmente avec un premier étage d'amplification 33 à fort gain et faible bruit, de façon à assurer une détection des trous de petites dimensions. Cette amplification 33 est à large bande, ce qui permet de traiter le film aluminisé 18 défilant à grande vitesse.

En ce qui concerne le traitement du signal numérique, les moyens pour détecter les trous et les moyens pour mesurer la densité optique comprennent de préférence un convertisseur de tension analogique-numérique commun 34. Le convertisseur analogique-numérique commun 34 est connecté à l'étage d'amplification commun 33. Un convertisseur analogique-numérique 16 ou 24 bits assure une haute résolution pour une détection des trous de petites dimensions. Le haut débit d'échantillonnage permet de traiter le film aluminisé 18 défilant à grande vitesse, allant jusqu'à 1500 m/min.

Les moyens pour détecter les trous et les moyens pour mesurer la densité optique comprennent de préférence un processeur commun pour traiter le signal 36. Le processeur commun pour traiter le signal 36 est connecté au convertisseur analogique-numérique 34. Le processeur commun 36 est apte à traiter séparément un signal numérique correspondant à une détection des trous 37 et un signal numérique correspondant à une mesure de la densité optique 38. La photodiode 32, l'étage d'amplification 33, le convertisseur 34, le processeur 36 sont disposés au niveau de l'élément optoélectronique récepteur 29.

Les moyens pour mesurer la densité optique comprennent de préférence un deuxième récepteur de lumière, sous la forme d'une deuxième photodiode 39 pour assurer une boucle de contrôle. La deuxième photodiode 39. reçoit une fraction de la lumière émise par la LED 31, via un miroir 41.

La deuxième photodiode 39 est connectée à un organe de régulation de la puissance 42 de la LED 31. L'organe de régulation 42 de la puissance de la LED 31 est connecté à la LED 31, et est apte à stabiliser la puissance lumineuse de la LED 31. Cette régulation en boucle de la lumière émise garanti un flux de lumière stable et évite les dérives thermiques, ce qui permet aussi de limiter un vieillissement prématuré de la LED 31. La LED 31, la deuxième photodiode 39 et l'organe de régulation de la puissance 42, sont disposés au niveau de l'élément optoélectronique émetteur 28.

Les moyens pour mesurer la densité optique comprennent de préférence également un atténuateur 43. L'atténuateur 43 est connecté à l'organe de régulation 42 de la puissance de la LED 31, et est apte à réguler la puissance de la LED 31. L'atténuateur 43 est disposé au niveau de l'élément optoélectronique émetteur 28. Avec l'atténuateur 43, la LED 31 peut émettre à différentes intensités de flux, de 1% à 100%, ce qui permet d'accroître la gamme de mesure de densités optiques, lorsque le film aluminisé 18 est transparent ou au contraire très opaque.

En ce qui concerne l'optique, au moins l'un des deux éléments, l'élément optoélectronique émetteur 28 et/ou l'élément optoélectronique récepteur 29, est équipé avec une fente 44. Dans l'exemple de réalisation, les deux éléments sont équipés avec une fente 44, respectivement une fente d'émission et une fente de réception. Les fentes 44 sont respectivement placées devant la LED 31 et devant la photodiode 32. Des jeux de déflecteurs peuvent être rajoutés pour permettre que détection et mesure ne soient pas influencées par la lumière environnante.

En ce qui concerne l'optique, au moins l'un des deux éléments, l'élément optoélectronique émetteur 28 et/ou l'élément optoélectronique récepteur 29 est équipé avec une lentille 46. Dans l'exemple de réalisation, les deux éléments sont équipés avec une lentille 46 de façon à obtenir un flux de lumière homogène le long de la fente 44. Les lentilles 46 sont respectivement placées devant la LED 31 et devant la photodiode 32 en étant intercalées entre la LED 31 et sa fente 44, et entre la photodiode 32 et sa fente 44. La lentille 46 est asphérique de façon à garantir un flux de lumière uniforme sur toute la longueur de la fente 44. Ainsi la détection de trous et la mesure de densité optique est homogène sur toute la longueur de la fente 44 et ainsi sur toute de la laize du film aluminisé 18.

L'élément optoélectronique émetteur 28 et l'élément optoélectronique récepteur 29 du dispositif 23 sont placés chacun dans des boîtiers étanches. Ces boîtiers et l'élément optoélectronique émetteur 28 et l'élément optoélectronique récepteur 29 sont compatibles pour que leurs électroniques fonctionnent sous vide. Les boîtiers protègent de la poussière, et notamment de la poudre d'aluminium se trouvant dans l'enceinte 3.

La présente invention n'est pas limitée aux modes de réalisation décrits et illustrés. De nombreuses modifications peuvent être réalisées, sans pour autant sortir du cadre défini par la portée du jeu de revendications.

A titre d'exemple, le dispositif selon l'invention peut également être utilisé dans une machine de type dérouleur-refendeur ou « slitter-rewinder », pour éliminer pendant une opération de reprise, les zones de film dont la surface présente des défauts d'enduction.

## Revendications

1. Procédé pour enduire un substrat en bande continue (18), dans une machine d'enduction (1), comprenant les étapes consistant à:
- dérouler (U) à partir d'une première bobine (6) et faire défiler (F) le substrat à enduire (2),
- enduire en continu par vaporisation sous vide d'un matériau d'enduction sur l'une des surfaces (14) du substrat défilant (2),
- enrouler le substrat enduit (18) sur une deuxième bobine (19),:
- émettre de la lumière avec un élément optoélectronique émetteur (28)
- capter la lumière transmise à travers le substrat enduit défilant (18) à l'aide d'un élément optoélectronique récepteur (29); l'élément optoélectronique émetteur (28) et élément optoélectronique récepteur (29) étant placés l'un en face de l'autre de part et d'autre du substrat enduit défilant (18),
- détecter en continu la présence de trous et mesurer en continu la densité optique dans toute ou partie du substrat enduit défilant (18),
**caractérisé en ce qu'**il comprend en outre les étapes consistant à
- mesurer en continu la densité optique de toute ou partie de la surface (14) du substrat enduit défilant (18)
- générer des signaux qui sont fonctions des trous détectés et de la densité optique mesurée,
- ajuster en continu les réglages de la machine (1) en fonction des signaux générés, intercalées entre l'étape consistant à enduire en continu substrat défilant (2), et l'étape consistant à enrouler le substrat enduit (18).

2. Procédé selon la revendication 1, où la puissance d'émission, lors de l'étape d'émission de la lumière avec l'élément optoélectronique émetteur (28), est stabilisée grâce à une boucle de contrôle faisant intervenir une LED (31) de l'émetteur, un organe de régulation (42) connecté à la LED (31), et une photodiode (39) qui reçoit une fraction de la lumière émise par la LED 31, via un miroir (41).

3. Procédé selon la revendication 1 ou 2, **caractérisé en ce que** l'étape de détection en continu de la présence de trous consiste également à déterminer la taille et/ou la superficie des trous et à les classifier.

4. Procédé selon la revendication 1,2 ou 3, **caractérisé en ce que** les étapes consistant à détecter en continu la présence de trous et à mesurer en continu la densité optique sont mises en œuvre sur toute la laize du substrat enduit (18).

5. Procédé selon l'une quelconque des revendications 1 à 4, **caractérisé en ce que** l'étape consistant à ajuster les réglages comprend une ou plusieurs des phases consistant à :
- régler automatiquement et en continu une puissance de vaporisation dans l'étape consistant à enduire ;
- régler automatiquement et en continu une vitesse d'arrivée du matériau d'enduction (17) dans l'étape consistant à enduire ;
- régler automatiquement et en continu une vitesse du substrat (2) dans l'étape consistant à faire défiler le substrat ; et
- envoyer automatiquement et en continu un signal d'information correspondant à une opération à effectuer sur la machine (1).

6. Machine d'enduction d'un substrat en bande continue (2), équipée avec une enceinte sous vide (3), comprenant :
- une première bobine (6) pour dérouler le substrat à enduire (2),
- des moyens (7, 8, 9, 11, 21) pour faire défiler le substrat (2),
- un banc pour vaporiser (13) un matériau d'enduction sur l'une des surfaces (14) du substrat (2), disposé à proximité de la surface (14),
- un agencement (16) pour alimenter en continu le banc (13) avec le matériau d'enduction (17) à vaporiser à la surface (14) du substrat défilant (2),
- une deuxième bobine (19) pour enrouler le substrat enduit (18), et
- une unité de pilotage (22) de la machine (1),
**caractérisée en ce qu'**elle comprend un dispositif (23) pour déterminer la qualité d'enduction du substrat enduit (18), muni de moyens pour détecter en continu des trous dans toute ou partie du substrat enduit défilant (18) et de moyens pour mesurer en continu une densité optique de toute ou partie de la surface du substrat enduit défilant (18), positionné dans l'enceinte (3) entre le banc de vaporisation (13) et la deuxième bobine (19), et connecté à l'unité de pilotage (22),
le dispositif comprenant en outre au moins un élément optoélectronique émetteur (28) et au moins un élément optoélectronique récepteur (29), disposés respectivement l'un en face de l'autre de part et d'autre du substrat enduit (18), les moyens pour mesurer la densité optique comprennent un deuxième récepteur de lumière (39), recevant une fraction de la lumière émise par la source de lumière (31), connecté à un organe de régulation (42) de la puissance de la source de lumière (31) apte à stabiliser la puissance de la source de lumière (31), et disposé au niveau de l'élément optoélectronique émetteur (28).

7. Machine selon la revendication 6, **caractérisée en ce que** le dispositif (23) comprend plusieurs modules, comprenant chacun les moyens pour détecter en continu les trous et les moyens pour mesurer en continu la densité optique, et disposés les uns par rapport aux autres de façon à être aptes à analyser toute la laize du substrat enduit (18).

8. Machine selon la revendication 7, **caractérisée en ce que** l'élément optoélectronique émetteur (28) et l'élément optoélectronique récepteur (29) sont chacun montés sur un rail.

9. Dispositif pour déterminer la qualité d'enduction d'un substrat en bande continue défilant enduit (18), muni de moyens pour détecter en continu des trous dans toute ou partie du substrat (18), sous la forme d'un élément optoélectronique émetteur (28) avec une source de lumière (31) placé d'un côté du substrat (18) et un élément optoélectronique récepteur (29) avec un récepteur de lumière (32) placé de l'autre côté du substrat (18), **caractérisé en ce qu'**il comprend des moyens pour mesurer en continu une densité optique de toute ou partie de la surface du substrat (18) ; ces moyens comprennent un deuxième récepteur de lumière (39), recevant une fraction de la lumière émise par la source de lumière (31), connecté à un organe de régulation (42) de la puissance de la source de lumière (31) apte à stabiliser la puissance de la source de lumière (31), et disposé au niveau de l'élément optoélectronique émetteur (28)

10. Dispositif selon la revendication 9, **caractérisé en ce que** la source de lumière est une LED (31) et **en ce que** le récepteur de lumière est une photodiode (32).

11. Dispositif selon la revendication 10, **caractérisé en ce que** les moyens pour détecter les trous et les moyens pour mesurer la densité optique comprennent un étage d'amplification commun (33) connecté au récepteur de lumière (32), un convertisseur analogique-numérique commun (34) connecté à l'étage d'amplification (33), et un processeur commun (36) connecté au convertisseur analogique-numérique (34), apte à traiter séparément un signal numérique de détection des trous et un signal numérique de mesure de la densité optique, disposés au niveau de l'élément optoélectronique récepteur (29).

12. Dispositif selon l'une quelconque des revendications 9 à 11, **caractérisé en ce que** les moyens pour mesurer la densité optique comprennent un deuxième récepteur de lumière (39), recevant une fraction de la lumière émise par la source de lumière (31), connecté à un organe de régulation (42) de la puissance de la source de lumière (31) apte à stabiliser la puissance de la source de lumière (31), et disposé au niveau de l'élément optoélectronique émetteur (28).

13. Dispositif selon l'une quelconque des revendications 9 à 12, **caractérisé en ce que** les moyens pour mesurer la densité optique comprennent un atténuateur (43), connecté à un organe de régulation (42) de la puissance de la source de lumière (31) apte à réguler la puissance de la source de lumière (31), et disposé au niveau de l'élément optoélectronique émetteur (28).

14. Dispositif selon l'une quelconque des revendications 9 à 13, **caractérisé en ce qu'**au moins l'un des deux éléments (28, 29) est équipé avec une fente (44) et une lentille (46) pour obtenir un flux de lumière homogène sur la longueur de la fente (44).

15. Dispositif selon l'une quelconque des revendications 10 à 14, **caractérisé en ce que** la LED (31) émet une lumière monochromatique, de longueur d'onde sensiblement comprise entre 400 nm et 700 nm, de préférence sensiblement égale à 550 nm.

## Patentansprüche

1. Verfahren zum Beschichten eines Bahnsubstrats (18) in einer Beschichtungsmaschine (1), die Schritte umfassend, die darin bestehen:
- das zu beschichtende Substrat (2) von einer ersten Spule (6) abzurollen (U), und durchlaufen (F) zu lassen,
- kontinuierlich durch Vakuumverdampfung eine der Oberflächen (14) des durchlaufenden Substrats (2) mit einem Beschichtungsmaterial zu beschichten,
- das beschichtete Substrat (18) auf eine zweite Spule (19) aufzurollen,:
- Licht mit einem optoelektronischen Emissionselement (28) zu emittieren
- das durch das durchlaufende beschichtete Substrat (18) hindurch übertragene Licht mithilfe eines optoelektronischen Empfangselements (29) zu erfassen; wobei das optoelektronische Emissionselement (28) und das optoelektronische Empfangselement (29) einander gegenüber beiderseits des durchlaufenden beschichteten Substrats (18) platziert sind,
- kontinuierlich das Vorhandensein von Löchern detektieren und kontinuierlich die optische Dichte im gesamten durchlaufenden beschichteten Substrat (18) oder einem Teil davon zu messen,
**dadurch gekennzeichnet, dass** es weiter Schritte umfasst, die darin bestehen
- kontinuierlich die optische Dichte der gesamten Oberfläche (14) des durchlaufenden beschichteten Substrats (18) oder eines Teils davon zu messen
- Signale zu generieren, die von den detektierten Löchern und der gemessenen optischen Dichte abhängig sind,
- kontinuierlich die Einstellungen der Maschine (1) in Abhängigkeit von den generierten Signalen anzupassen,
eingeschoben zwischen den Schritt, der darin besteht, das durchlaufende Substrat (2) kontinuierlich zu beschichten, und den Schritt, der darin besteht, das beschichtete Substrat (18) aufzurollen.

2. Verfahren nach Anspruch 1, wo die Emissionsleistung beim Schritt des Emittierens des Lichts mit dem optoelektronischen Emissionselement (28) dank einer Kontrollschleife stabilisiert wird, die eine LED (31) des Emitters, ein Regelungsorgan (42), das mit der LED (31) verbunden ist, und eine Photodiode (39) eingreifen lässt, die eine Fraktion des Lichts, das durch die LED (31) emittiert wird, über einen Spiegel (41) empfängt.

3. Verfahren nach Anspruch 1 oder 2, **dadurch gekennzeichnet, dass** der Schritt des kontinuierlichen Detektierens des Vorhandenseins von Löchern auch darin besteht, die Größe und/ oder die Flächenausdehnung der Löcher zu bestimmen und sie einzustufen.

4. Verfahren nach Anspruch 1, 2 oder 3, **dadurch gekennzeichnet, dass** die Schritte, die darin bestehen, kontinuierlich das Vorhandensein von Löchern zu detektieren, und kontinuierlich die optische Dichte zu messen, auf der gesamte Breite des beschichteten Substrats (18) ausgeführt werden.

5. Verfahren nach einem der Ansprüche 1 bis 4, **dadurch gekennzeichnet, dass** der Schritt, der darin besteht, die Einstellungen anzupassen, eine oder mehrere Phasen umfasst, die darin bestehen:
- automatisch und kontinuierlich eine Verdampfungsleistung in dem Schritt einzustellen, der aus dem Beschichten besteht;
- automatisch und kontinuierlich eine Ankunftsgeschwindigkeit des Beschichtungsmaterials (17) in dem Schritt einzustellen, der aus dem Beschichten besteht;
- automatisch und kontinuierlich eine Geschwindigkeit des Substrats (2) in dem Schritt einzustellen, der darin besteht, das Substrat durchlaufen zu lassen; und
- automatisch und kontinuierlich ein Informationssignal zu senden, das einem an der Maschine (1) durchzuführenden Vorgang entspricht.

6. Maschine zum Beschichten eines Bahnsubstrats (2), die mit einem unter Vakuum stehenden Raum (3) ausgestattet ist, Folgendes umfassend:
- eine erste Spule (6) zum Abrollen des zu beschichtenden Substrats (2),
- Mittel (7, 8, 9, 11, 21) zum Durchlaufenlassen des Substrats (2),
- eine Bank zum Verdampfen (13) eines Beschichtungsmaterials auf eine der Oberflächen (14) des Substrats (2), die in der Nähe der Oberfläche (14) angeordnet ist,
- eine Anordnung (16) zum kontinuierlichen Versorgen der Bank (13) mit dem Beschichtungsmaterial (17), das auf die Oberfläche (14) des durchlaufenden Substrats (2) zu beschichten ist,
- eine zweite Spule (19) zum Aufrollen des beschichteten Substrats (18), und
- eine Ansteuerungseinheit (22) der Maschine (1),
**dadurch gekennzeichnet, dass** sie eine Vorrichtung (23) zum Bestimmen der Beschichtungsqualität des beschichteten Substrats (18) umfasst, die mit Mitteln zum kontinuierlichen Detektieren der Löcher auf dem gesamten durchlaufenden beschichteten Substrat (18) oder eines Teils davon, und Mitteln zum kontinuierlichen Messen einer optischen Dichte der gesamten Oberfläche des durchlaufenden beschichteten Substrats (18) oder eines Teils davon versehen ist, die in dem Raum (3) zwischen der Verdampfungsbank (13) und der zweiten Spule (19) positioniert ist, und mit der Ansteuerungseinheit (22) verbunden ist,
wobei die Vorrichtung weiter mindestens ein optoelektronisches Emissionselement (28) und ein optoelektronisches Empfangselement (29) umfasst, die jeweils einander gegenüber, beiderseits des durchlaufenden beschichteten Substrats (18) angeordnet sind,
die Mittel zum Messen der optischen Dichte einen zweiten Lichtempfänger (39) umfassen, der eine Fraktion des durch die Lichtquelle (31) emittierten Lichts empfängt, der mit einem Regelungsorgan (42) der Leistung der Lichtquelle (31) verbunden ist, das imstande ist, die Leistung der Lichtquelle (31) zu stabilisieren, und im Bereich des optoelektronischen Emissionselements (28) angeordnet ist.

7. Maschine nach Anspruch 6, **dadurch gekennzeichnet, dass** die Vorrichtung (23) mehrere Module umfasst, die jeweils die Mittel zum kontinuierlichen Detektieren der Löcher und die Mittel zum kontinuierlichen Messen der optischen Dichte umfassen, und zueinander in der Art angeordnet sind, um imstande zu sein, die gesamte Breite des beschichteten Substrats (18) zu analysieren.

8. Maschine nach Anspruch 7, **dadurch gekennzeichnet, dass** das optoelektronische Emissionselement (28) und das optoelektronische Empfangselement (29) jeweils auf einer Schiene montiert sind.

9. Vorrichtung zum Bestimmen der Beschichtungsqualität eines beschichteten durchlaufenden Bahnsubstrats (18), das mit Mitteln zum kontinuierlichen Detektieren der Löcher im gesamten Substrat (18) oder einem Teil davon versehen ist, in Form eines optoelektronischen Emissionselements (28) mit einer Lichtquelle (31), das auf einer Seite des Substrats (18) platziert ist, und eines optoelektronischen Empfangselements (29) mit einem Lichtempfänger (32), der auf der anderen Seite des Substrats (18) platziert ist, **dadurch gekennzeichnet, dass** sie Mittel zum kontinuierlichen Messen einer optischen Dichte der gesamten Oberfläche des Substrats (18) oder eines Teils davon umfasst; diese Mittel einen zweiten Lichtempfänger (39) umfassen, der eine Fraktion des durch die Lichtquelle emittierten Lichts empfängt, der mit einem Regelungsorgan (42) der Leistung der Lichtquelle (31) verbunden ist, das imstande ist, die Leistung der Lichtquelle (31) zu stabilisieren, und im Bereich des optoelektronischen Emissionselements (28) angeordnet ist.

10. Vorrichtung nach Anspruch 9, **dadurch gekennzeichnet, dass** die Lichtquelle eine LED (31) ist und dadurch, dass der Lichtempfänger eine Photodiode (32) ist.

11. Vorrichtung nach Anspruch 10, **dadurch gekennzeichnet, dass** die Mittel zum Detektieren der Löcher und die Mittel zum Messen der optischen Dichte eine gemeinsame Verstärkungsstufe (33), die mit dem Lichtempfänger (32) verbunden ist, einen gemeinsamen Analog-Digital-Wandler (34), der mit der Verstärkungsstufe (33) verbunden ist, und einen gemeinsamen Prozessor (36), der mit dem Analog-Digital-Wandler (34) verbunden ist, umfassen, der imstande ist, getrennt ein digitales Signal zum Detektieren der Löcher und ein digitales Signal zum Messen der optischen Dichte zu verarbeiten, die im Bereich des optoelektronischen Empfangselements (29) angeordnet sind.

12. Vorrichtung nach einem der Ansprüche 9 bis 11, **dadurch gekennzeichnet, dass** die Mittel zum Messen der optischen Dichte einen zweiten Lichtempfänger (39) umfassen, der eine Fraktion des durch die Lichtquelle (31) emittierten Lichts empfängt, der mit einem Regelungsorgan (42) der Leistung der Lichtquelle (31) verbunden ist, das imstande ist, die Leistung der Lichtquelle (31) zu stabilisieren, und im Bereich des optoelektronischen Emissionselements (28) angeordnet ist.

13. Vorrichtung nach einem der Ansprüche 9 bis 12, **dadurch gekennzeichnet, dass** die Mittel zum Messen der optischen Dichte einen Dämpfer (43) umfassen, der mit einem Regelungsorgan (42) der Leistung der Lichtquelle (31) verbunden ist, das imstande ist, die Leistung der Lichtquelle (31) zu regeln, und im Bereich des optoelektronischen Emissionselements (28) angeordnet ist.

14. Vorrichtung nach einem der Ansprüche 9 bis 13, **dadurch gekennzeichnet, dass** mindestens das eine der beiden optoelektronischen Emissionselemente (28, 29) mit einem Schlitz (44) und einer Linse (46) ausgestattet ist, um einen homogenen Lichtfluss über die Länge des Schlitzes (44) zu erhalten.

15. Vorrichtung nach einem der Ansprüche 10 bis 14, **dadurch gekennzeichnet, dass** die LED (31) ein einfarbiges Licht mit einer Wellenlänge, die im Wesentlichen zwischen 400 nm und 700 nm enthalten ist, vorzugsweise im Wesentlichen gleich 550 nm, emittiert.

## Claims

1. Method for coating a continuous web substrate (18), in a coating machine (1), comprising the steps of:
- unwinding (U) the substrate to be coated (2) from a first reel (6) and moving it (F),
- continuously applying a coating material by vacuum spraying onto one of the surfaces (14) of the moving substrate (2),
- winding the coated substrate (18) onto a second reel (19),
- emitting light with an optoelectronic emitting element (28),
- receiving the light transmitted through the moving coated substrate (18) using an optoelectronic receiving element (29); the optoelectronic emitting element (28) and the optoelectronic receiving element (29) being arranged facing each other on either side of the moving coated substrate (18),
- continuously detecting the presence of holes and continuously measuring the optical density of all or part of the moving coated substrate (18),
**characterised in that** it also comprises the steps of
- continuously measuring the optical density of all or part of the surface (14) of the moving coated substrate (18)
- generating signals in accordance with holes detected and the optical density measured,
- continuously adjusting the settings of the machine (1) in accordance with signals generated, in between the step of continuously coating the moving substrate (2) and the step of winding the coated substrate (18).

2. Method according to claim 1, wherein the emission power, during the step of emitting light with the optoelectronic emitting element (28), is stabilised thanks to a control loop involving an LED (31) of the emitter, a controller (42) connected to the LED (31) and a photodiode (39), which receives a fraction of the light emitted by the LED (31), via a mirror (41).

3. Method according to claim 1 or 2, **characterised in that** the step of continuously detecting the presence of holes also consists of determining the size and/or the surface area of holes and classifying them.

4. Method according to claim 1, 2 or 3, **characterised in that** the steps of continuously detecting the presence of holes and continuously measuring optical density are implemented over the entire width of the coated substrate (18).

5. Method according to any of claims 1 to 4, **characterised in that** the step of adjusting the settings comprises one or more phases consisting of:
- automatically and continuously adjusting a spraying power in the step of coating,
- automatically and continuously adjusting an arrival speed of the coating material (17) in the step of coating,
- automatically and continuously adjusting a speed of the substrate (2) in the step of moving the substrate, and
- automatically and continuously sending an information signal corresponding to an operation to be performed on the machine (1).

6. Machine for continuously coating a web substrate (2), equipped with a vacuum chamber (3), comprising:
- a first reel (6) for unwinding the substrate to be coated (2),
- means (7, 8, 9, 11, 21) for moving the substrate (2),
- a bench for spraying (13) a coating material onto one of the surfaces (14) of the substrate (2), arranged close to the surface (14),
- an arrangement (16) for continuously supplying the bench (13) with the coating material (17) to be sprayed onto the surface (14) of the moving substrate (2),
- a second reel (19) for winding the coated substrate (18), and
- a control unit (22) for the machine (1),
**characterised in that** it comprises a device (23) for determining the coating quality of the coated substrate (18), provided with means for continuously detecting holes in all or part of the moving coated substrate (18) and means for continuously measuring an optical density of all or part of the surface of the moving coated substrate (18), positioned in the chamber (3) between the spray bench (13) and the second reel (19), and connected to the control unit (22),
the device also comprises at least one optoelectronic emitting element (28) and at least one optoelectronic receiving element (29), arranged respectively on one side and the other of the coated substrate (18),
the means for measuring optical density comprise a second light receiver (39), receiving a fraction of the light emitted by the light source (31), connected to a controller (42) for controlling the power of the light source (31), which is able to stabilise the power of the light source (31), and arranged at the optoelectronic emitting element (28).

7. Machine according to claim 6, **characterised in that** the device (23) comprises several modules, each comprising the means for continuously detecting holes and the means for continuously measuring optical density, and arranged relative to each other such that they are able to analyse the entire width of the substrate (18).

8. Machine according to claim 7, **characterised in that** the optoelectronic emitting element (28) and the optoelectronic receiving element (29) are each mounted on a rail.

9. Device for determining the coating quality of a moving coated continuous web substrate (18), provided with means for continuously detecting holes in all or part of the substrate (18), in the form of an optoelectronic emitting element (28) with a light source (31) placed on one side of the substrate (18) and an optoelectronic receiving element (29) with a light receiver (32) placed on the other side of the substrate (18), **characterised in that** it comprises means for continuously measuring an optical density of all or part of the surface of the substrate (18); these means comprise a second light receiver (39), receiving a fraction of the light emitted by the light source (31), connected to a controller (42) for controlling the power of the light source (31), which is able to stabilise the power of the light source (31), and arranged at the optoelectronic emitting element (28).

10. Device according to claim 9, **characterised in that** the light source is an LED (31) and **in that** the light receiver is a photodiode (32).

11. Device according to claim 10, **characterised in that** the means for detecting holes and the means for measuring optical density comprise a common amplification stage (33) connected to the light receiver (32), a common analog-to-digital converter (34) connected to the amplification stage (33) and a common processor (36) connected to the analog-to-digital converter (34), which are able to separately process a digital signal for detecting holes and a digital signal for measuring optical density, arranged at the optoelectronic receiving element (29).

12. Device according to any of claims 9 to 11, **characterised in that** the means for measuring optical density comprise a second light receiver (39), receiving a fraction of the light emitted by the light source (31), connected to a controller (42) for controlling the power of the light source (31), which is able to stabilise the power of the light source (31), and arranged at the optoelectronic emitting element (28).

13. Device according to any of claims 9 to 12, **characterised in that** the means for measuring optical density comprise an attenuator (43), connected to a controller (42) for controlling the power of the light source (31), which is able to control the power of the light source (31), and arranged at the optoelectronic emitting element (28).

14. Device according to any of claims 9 to 13, **characterised in that** at least one of the two elements (28, 29) is equipped with a slot (44) and a lens (46) to obtain a homogenous light flux over the length of the slot (44).

15. Device according to any of claims 10 to 14, **characterised in that** the LED (31) emits a monochromatic light, with a wavelength substantially between 400 nm and 700 nm, preferably substantially equal to 550 nm.
